# EUROPEAN PATENT APPLICATION

(11) **EP 3 185 115 A1**
(43) Date of publication of application: **28.06.2017**
(21) Application number: 16204279.0
(22) Date of filing: 15.12.2016
(51) Int. Cl.: G06F 3/0488, G06F 3/041, G06F 3/0481

(54) **TOUCH BUTTON MODULE, METHOD AND APPARATUS FOR DISPLAYING A BUTTON ICON**

(30) Priority: 24.12.2015 CN 201510991882
(71) Applicant: Xiaomi Inc., Beijing 100085 (CN)
(72) Inventor: WANG, Gang, Beijing, Beijing 100085 (CN); HAO, Ning, Beijing, Beijing 100085 (CN); SHI, Shasha, Beijing, Beijing 100085 (CN)
(74) Representative: dompatent von Kreisler Selting Werner - Partnerschaft von Patent- und Rechtsanwälten mbB

(57) **Abstract**

Touch button module, method and apparatus for displaying a button icon are disclosed in the disclosure, which belong to display technology field. The touch button module includes a sensing layer (110), a luminous layer (140), an integrated circuit (IC) layer (120), and a pin (130), which are wholly integrated. An electronic device may determine (301) a function item corresponding to the touch button module, and then determine (302) button icon information corresponding to the function item. The electronic device may transmit (303) the button icon information to an IC layer of the touch button module. The IC layer may control illuminants in a luminous layer to emit light. Therefore, the problem of the state of the art that the button icon displayed by a LED light is fixed due to a fixed pattern of a hollow area corresponding to the button icon may thus be solved.

## Description

### FIELD

The present disclosure generally relates to the field of display technology and, in particular, to touch button module, method and apparatus for displaying a button icon.

### BACKGROUND

A touch button module is an electronic module to collect touch operations of a user. Typically, the touch button module is disposed on the front of an electronic device as a button.

A touch button module in prior art includes a sensing device, a LED light located above the sensing device, and an integrated circuit (IC) connected to the sensing device and the LED light respectively. When the touch button module is installed on the electronic device, there is a layer of ink disposed above the LED light, on which a hollow area corresponding to a button icon is formed. Pattern of the hollow area is fixed.

When the touch button module is working, the LED light is controlled by the IC to emit light, which goes through the hollow area to form the button icon.

### SUMMARY

In view of the fact in prior art, a touch button module, a method and apparatus for displaying a button icon are provided in the present disclosure. The technical solutions are described as follows.

According to a first aspect of the present disclosure, a touch button module is provided, including a sensing layer, a luminous layer, an integrated circuit (IC) layer, and a pin, which are wholly integrated, wherein the luminous layer is located below the sensing layer, which comprises a plurality of illuminants arranged in an array; the IC layer is located below the luminous layer; the pin is located below the IC layer; and the sensing layer is electrically connected to the IC layer through a first conductive line, the luminous layer is electrically connected to the IC layer through a second conductive line, and the pin is electrically connected to the IC layer through a third conductive line.

Alternatively, light transmittance of the sensing layer is greater than a pre-defined threshold.

According to a second aspect of the present disclosure, a method for displaying a button icon, which is applied to an electronic device configured with a touch button module of any of the touch button module provided in the first aspect, including: determining a function item corresponding to the touch button module; determining button icon information corresponding to the function item, which indicates a pattern of the button icon; and transmitting the button icon information to an IC layer of the touch button module, which controls illuminants in a luminous layer to emit light according to the button icon information.

Alternatively, the determining the function item corresponding to the touch button module includes: obtaining function information pre-defined in the electronic device by a user, which comprises a correspondence between the touch button module and the function item; and determining the function item corresponding to the touch button module according to the function information.

Alternatively, the determining the function item corresponding to the touch button module includes: obtaining a type of an application program which is currently running in the electronic device; and determining the function item corresponding to the touch button module according to the type of the application program.

Alternatively, the determining the function item corresponding to the touch button module includes: obtaining a display interface of an application program which is currently running in the electronic device; and determining the function item corresponding to the touch button module according to the display interface of the application program.

Alternatively, the determining the function item corresponding to the touch button module includes: obtaining a type of prompt information received by the electronic device; and determining the function item corresponding to the touch button module according to the type of the prompt information.

Alternatively, the determining the function item corresponding to the touch button module includes: receiving a type of a trigger signal transmitted by the touch button module; and determining the function item corresponding to the touch button module according to the type of the trigger signal.

Alternatively, the determining the button icon information corresponding to the function item includes: obtaining a list of correspondence between the function item and the button icon information; and inquiring the button icon information corresponding to the function item according to the list of correspondence.

According to a third aspect of the present disclosure, an apparatus for displaying a button icon, which is applied to an electronic device configured with the touch button module of any of the touch button module provided in the first aspect, including: a function determination module configured to determine a function item corresponding to the touch button module; an information determination module configured to determine button icon information corresponding to the function item, which indicates a pattern of the button icon; and an information transmission module configured to transmit the button icon information to an IC layer of the touch button module, which controls illuminants in a luminous layer to emit light according to the button icon information.

Alternatively, the function determination module includes: a first obtaining sub-module configured to obtain function information pre-defined in the electronic device by a user, which comprises a correspondence between the touch button module and the function item; and a first determination sub-module configured to determine the function item corresponding to the touch button module according to the function information.

Alternatively, the function determination module includes: a second obtaining sub-module configured to obtain a type of an application program which is currently running in the electronic device; and a second determination sub-module configured to determine the function item corresponding to the touch button module according to the type of the application program.

Alternatively, the function determination module includes: a third obtaining sub-module configured to obtain a display interface of an application program which is currently running in the electronic device; and a third determination sub-module configured to determine the function item corresponding to the touch button module according to the display interface of the application program.

Alternatively, the function determination module includes: a fourth obtaining sub-module, configured to obtain a type of prompt information received by the electronic device; and a fourth determination sub-module configured to determine the function item corresponding to the touch button module according to the type of the prompt information.

Alternatively, the function determination module includes: a signal reception sub-module configured to obtain a type of a trigger signal transmitted by the touch button module; and a fifth determination sub-module configured to determine the function item corresponding to the touch button module according to the type of the trigger signal.

Alternatively, the function determination module includes: a fifth obtaining sub-module configured to obtain a list of correspondence between the function item and the button icon information; and an information inquiring sub-module configured to inquire the button icon information corresponding to the function item according to the list of correspondence.

According to a fourth aspect of the present disclosure, an apparatus for displaying a button icon is provided, including: a processor; and a memory to store processor-executable instructions; the processor is electrically connected to a touch button module through a conductive line on a mainboard; wherein the processor is configured to: determine a function item corresponding to the touch button module; determine button icon information corresponding to the function item, which indicates a pattern of the button icon; and transmit the button icon information to an IC layer of the touch button module, which controls illuminants in a luminous layer to emit light according to the button icon information.

The technical solutions provided by embodiments of the present disclosure may achieve the following beneficial effects. The touch button module is formed by wholly integrating a sensing layer, a luminous layer, an integrated circuit (IC) layer, and a pin. An electronic device may determine a function item corresponding to the touch button module, and then determine button icon information corresponding to the function item. The electronic device may transmit the button icon information to an IC layer of the touch button module. The IC layer may control illuminants in a luminous layer to emit light. Therefore, the problem of the prior art that the button icon displayed by a LED light is fixed due to a fixed pattern of a hollow area corresponding to the button icon may be thus solved in the present invention. In contrary, the button icon information can be determined according to the function item and the illuminants in the luminous layer emit light under the control of the IC layer. Therefore, different function items correspond to different patterns of the button icon, thus achieving a diversity of the patterns of the button icon.

It is to be understood that both the forgoing general description and the following detailed description are exemplary only, and are not restrictive of the present disclosure.

### BRIEF DESCRIPTION OF THE DRAWINGS

The accompanying drawings, which are incorporated in and constitute a part of this specification, and illustrate embodiments consistent with the disclosure, together with the description, serve to explain the principles of the disclosure.
Fig. 1 is a schematic structure diagram illustrating a touch button module according to prior art.
Fig. 2A is a schematic structure diagram illustrating a touch button module according to an exemplary embodiment.
Fig. 2B is a schematic structure diagram illustrating illuminants arranged in an array according to an exemplary embodiment.
Fig. 2C is a stereogram of the touch button module shown in Fig. 2A.
Fig. 3 is a flow chart illustrating a method for displaying a button icon according to an exemplary embodiment.
Fig. 4A is a flow chart illustrating a method for displaying a button icon according to another exemplary embodiment.
Fig. 4B is a schematic diagram illustrating a function item corresponding to a touch button module according to an exemplary embodiment.
Fig. 4C is a schematic diagram illustrating another function item corresponding to a touch button module according to an exemplary embodiment.
Fig. 4D is a schematic diagram illustrating a kind of illuminants emitting light for display according to an exemplary embodiment.
Fig. 4E is a schematic diagram illustrating another kind of illuminants emitting light for display according to an exemplary embodiment.
Fig. 5A is a flow chart illustrating a method for displaying a button icon according to another exemplary embodiment.
Fig. 5B is a schematic diagram illustrating a function item corresponding to a touch button module according to another exemplary embodiment.
Fig. 5C is a schematic diagram illustrating another function item corresponding to the touch button module according to another exemplary embodiment.
Fig. 5D is a flow chart illustrating a method for displaying a button icon according to another exemplary embodiment.
Fig. 5E is a flow chart illustrating a method for displaying a button icon according to another exemplary embodiment.
Fig. 5F is a schematic diagram illustrating a function item corresponding to a touch button module according to another exemplary embodiment.
Fig. 5G is a schematic diagram illustrating another function item corresponding to a touch button module according to another exemplary embodiment.
Fig. 5H is a flow chart illustrating a method for displaying a button icon according to another exemplary embodiment.
Fig. 5I is a flow chart illustrating a method for displaying a button icon according to another exemplary embodiment.
Fig. 6 is a block diagram illustrating an apparatus for displaying a button icon according to an exemplary embodiment.
Fig. 7 is a block diagram illustrating an apparatus for displaying a button icon according to another exemplary embodiment.
Fig. 8 is a block diagram illustrating an apparatus for displaying a button icon according to an exemplary embodiment.

### DETAILED DESCRIPTION

Reference will now be made in detail to exemplary embodiments, examples of which are illustrated in the accompanying drawings. The following description refers to the accompanying drawings in which same numbers in different drawings represent same or similar elements unless otherwise described. The implementations set forth in the following description of exemplary embodiments do not represent all implementations consistent with the present disclosure. Instead, they are merely examples of apparatuses and methods consistent with some aspects related to the present disclosure as recited in the appended claims.

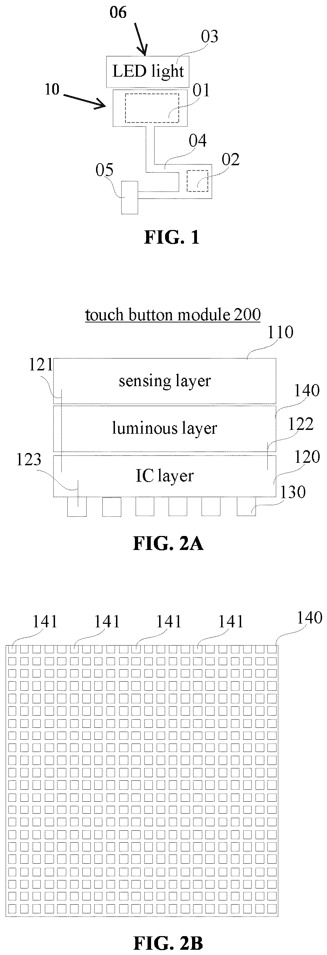

Fig. 1 is a schematic structure diagram illustrating a touch button module 10 according to prior art. As shown in Fig. 1, the touch button module 10 may include a sensing device 01, an IC 02, a LED light 03, and a flexible circuit board 04.

The LED light 03 is located above the sensing device 01, the IC 02 is connected to the sensing device 01, the LED light 03, and the flexible circuit board 04, respectively. A connector 05 is connected to the flexible circuit board 04. The touch button module 10 is connected to the mainboard of an electronic device through the connector 05. There is a layer of ink 06 disposed above the LED light 03, on which a hollow area corresponding to a button icon is formed.

Since the pattern of the hollow area corresponding to the button icon is fixed, after collecting a touch signal, the sensing device transmits the touch signal to the IC 02 which generates a touch event according to the touch signal and controls the LED light 03 to display the pattern of the corresponding hollow area in the button icon area.

Fig. 2A is a schematic structure diagram illustrating a touch button module 200 according to an exemplary embodiment. As shown in the side section view of the touch button module 200 in Fig. 2A, the touch button module 200 may include a sensing layer 110, an IC layer 120, a pin 130, and a luminous layer 140, which are wholly integrated.

The luminous layer 140 is located below the sensing layer 110, including a plurality of illuminants 141 arranged in an array, as shown in Fig. 2B.

The IC layer 120 is located below the luminous layer 140. The pin 130 is located below the IC layer 120. Alternatively, the pin 130 is a needle-like pin.

The sensing layer 110 is electrically connected to the IC layer 120 through a first conductive line 121. The luminous layer 140 is electrically connected to the IC layer 120 through a second conductive line 122. The pin 130 is electrically connected to the IC layer 120 through a third conductive line 123.

Alternatively, the sensing layer 110 is located above the IC layer 120.

Alternatively, light transmittance of the sensing layer 110 is greater than a pre-defined threshold.

For example, the sensing layer 110 is semitransparent or transparent.

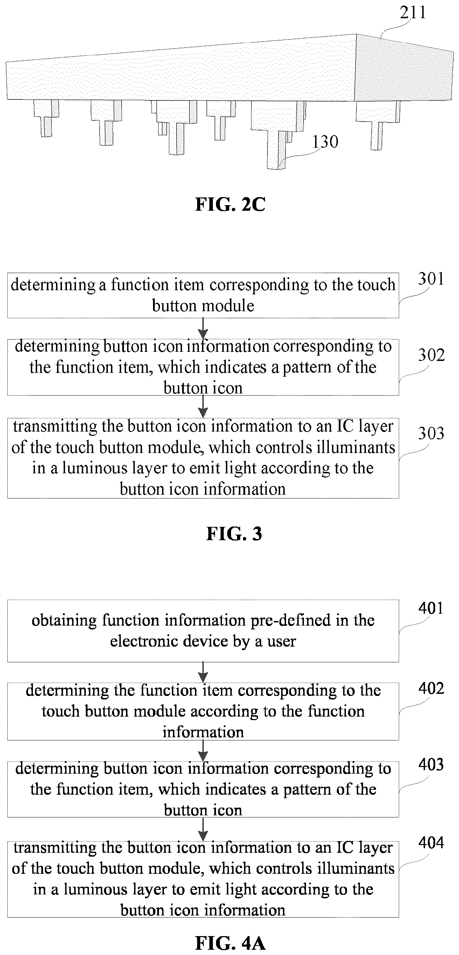

Fig. 2C is a stereogram 211 illustrating the touch button module 200, which includes the sensing layer 110, the luminous layer 140, and the IC layer 120. The pin 130 is located below the IC layer, as shown in Fig. 2C.

In conclusion, a touch button module is provided in the present disclosure, which is formed by wholly integrating a sensing layer, a luminous layer, an IC layer and a pin. An electronic device may determine a function item corresponding to the touch button module, and then determine button icon information corresponding to the function item. The electronic device may transmit the button icon information to an IC layer of the touch button module. The IC layer may control illuminants in a luminous layer to emit light. Therefore, the problem may thus be solved that the button icon displayed by a LED light is fixed since a pattern of a hollow area corresponding to the button icon is fixed. In contrary for the present invention, the button icon information can be determined according to the function item and the illuminants in the luminous layer emit light under the control of the IC layer. Therefore, different function items correspond to different patterns of the button icon, thus achieving a diversity of the patterns of the button icon.

Fig. 3 is a flow chart illustrating a method for displaying a button icon according to an exemplary embodiment. As shown in Fig. 3, the method for displaying the button icon is applied to an electronic device which is configured with a touch button module as shown in Fig. 2A. The method may include steps as follows.

At step 301, a function item corresponding to the touch button module is determined.

At step 302, button icon information corresponding to the function item is determined. The button icon information indicates the pattern of the button icon.

At step 303, the button icon information is transmitted to the IC layer of the touch button module. The IC layer controls the illuminants in the luminous layer to emit light according to the button icon information.

In conclusion, a method for displaying a button icon is provided in the present disclosure. By determining a function item corresponding to a touch button module; determining button icon information corresponding to the function item; and transmitting the button icon information to an IC layer of the touch button module, which may control illuminants in a luminous layer to emit light, the problem may thus be solved that the button icon displayed by a LED light is fixed since a pattern of a hollow area corresponding to the button icon is fixed. In contrary for the present invention, the button icon information can be determined according to the function item and the illuminants in the luminous layer emit light under the control of the IC layer. Therefore, different function items correspond to different patterns of the button icons, thus achieving a diversity of the patterns of the button icon.

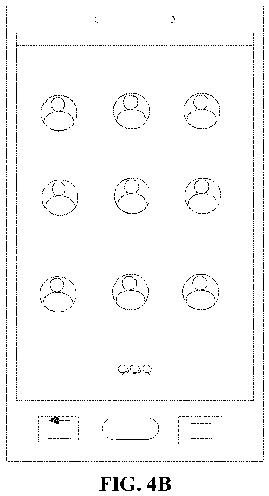

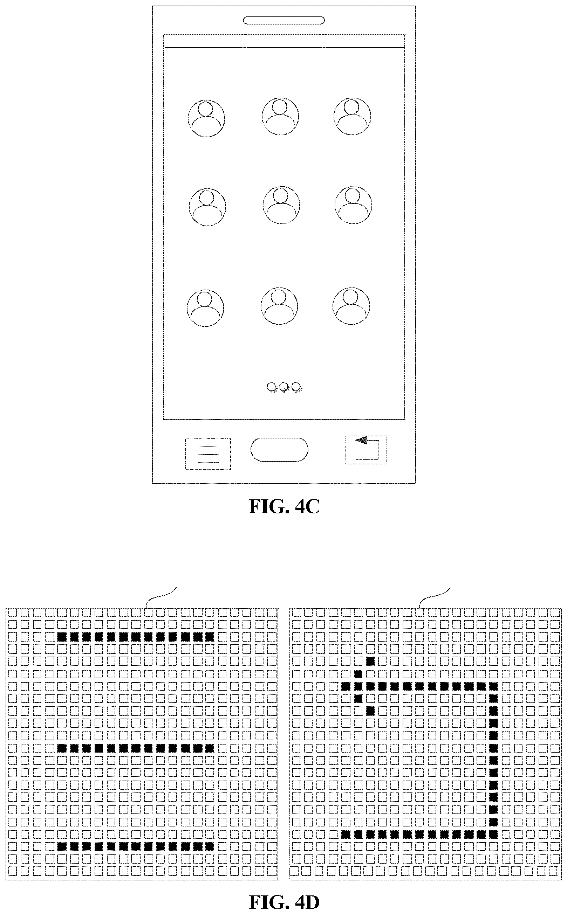

Fig. 4A is a flow chart illustrating a method for displaying a button icon according to another exemplary embodiment. As shown in Fig. 4A, the method for displaying the button icon is applied to an electronic device which is configured with a touch button module as shown in Fig. 2A. The method may include steps as follows.

At step 401, function information pre-defined by a user in the electronic device is obtained. The function information includes a correspondence between the touch button module and a function item.

The function information pre-defined by the user is obtained by the electronic device. The function information includes the correspondence between the touch button module and the function item.

For example, the function information corresponding to the touch button module, pre-defined by the user, is that the function item corresponding to the touch button module is to display a main page of the electronic device. For example, the function information corresponding to the touch button module, pre-defined by the user, is that the function item corresponding to the touch button module is to return to the last operation.

At step 402, the function item corresponding to the touch button module is determined according to the function information.

The function item corresponding to the touch button module is determined by the electronic device, according to the function information pre-defined by the user.

Alternatively, for different function information, the function items corresponding to the touch button module are different.

For example, two touch button modules are disposed on left and right sides of an area between a display screen and a lower edge of the electronic device. When the user pre-defines to hold the electronic device by right hand, the function information corresponding to the left touch button module is to "return to the last operation", while the function information corresponding to the right touch button module is to "display the main page of the electronic device", as shown in 4B.

For example, when the user pre-defines to hold the electronic device by left hand, the function information corresponding to the left touch button module is to "display the main page of the electronic device", while the function information corresponding to the right touch button module is to "return to the last operation", as shown in 4C.

In this embodiment, the electronic device configured with two button touch button modules is only for illustration. The electronic device may be configured with one button touch button module or multiple button touch button modules. The number of the button touch button modules which the electronic device may be configured with is not limited in this embodiment.

Alternatively, when the electronic device is configured with multiple touch button modules, the function item corresponding to each touch button module may be different.

At step 403, button icon information corresponding to the function item is determined. The button icon information indicates a pattern of the button icon.

After the function item corresponding to the touch button module is determined by a processor of the electronic device, the corresponding button icon information is determined according to the determined function item.

Each item of the button icon information indicates one pattern of the button icon.

That is, each function item corresponds to one item of the button icon information, and each item of the button icon information corresponds to one pattern of the button icon.

Alternatively, multiple function items may correspond to the same button icon information. That is, multiple function items may correspond to the same pattern of the button icon.

Alternatively, since a type of an application program which is currently running can be various, the function item corresponding to the same touch button module can also be various. Therefore, the button icon information corresponding to the same touch button module is various, and the pattern of the button icon corresponding to the same touch button module is also various.

For example, when the application program which is currently running is a shopping application program, the pattern of the button icon corresponding to the function item to "show items in a shopping cart of a logged-in user account" which corresponds to the left touch button module is "A", and the pattern of the button icon corresponding to the function item to "return to the main page of the electronic device" which corresponds to the right touch button module is "B".

For example, when the application program which is currently running is a social application program, the pattern of the button icon corresponding to the function item to "return to the main page of the electronic device" which corresponds to the left touch button module is also "B", and the pattern of the button icon corresponding to the function item to "show a list of unread messages" which corresponds to the right touch button module is "C".

Alternatively, when the function items corresponding to the touch button module are the same, the patterns of the button icon corresponding to the touch button module are also the same.

At step 404, the button icon information is transmitted to the IC layer in the touch button module, which controls the illuminants in the luminous layer to emit light according to the button icon information.

The determined button icon information is transmitted to the IC layer in the touch button module by the processor of the electronic device. The illuminants in the luminous layer are controlled to emit light by the IC layer according to the received button icon information.

The processor of the electronic device is electrically connected to a mainboard of the electronic device through a conductive line on the mainboard. The touch button module is electrically connected to the mainboard of the electronic device through the pin. The IC layer of the touch button module is electrically connected to the pin through a third conductive line. Therefore, the determined button icon information is transmitted to the IC layer by the processor of the electronic device through the conductive line on the mainboard and the pin.

Since the IC layer is electrically connected to the luminous layer through a second conductive line, the illuminants in the luminous layer are controlled to emit light by the IC layer according to the received button icon information.

The illuminants in the luminous layer emit light according to the button icon information, thus a graph formed by the light emitted by the illuminants is the same as the pattern of the button icon indicated in the button icon information.

The illuminants in the luminous layer are controlled to emit light by the IC layer according to different button icon information, thus obtaining different patterns of the button icon.

For example, when the application program which is currently running is the shopping application program, the button icon information corresponding to the function item 41 to "show items in a shopping cart of a logged-in user account" which corresponds to the left touch button module carries information of displaying three horizontal lines in the button icon. In this situation, a part of the illuminants arranged in an array in the luminous layer are controlled to emit light by the IC layer according to the button icon information, so that the button icon displayed by the light emitted by the illuminants is the "three horizontal lines" icon. The button icon information corresponding to the function item 42 to "return to the main page of the electronic device" which corresponds to the right touch button module carries information of displaying a return arrow in the button icon. In this situation, a part of the illuminants arranged in an array in the luminous layer are controlled to emit light by the IC layer according to the button icon information, so that the button icon displayed by the light emitted by the illuminants is the "return arrow" icon, as shown in Fig. 4D.

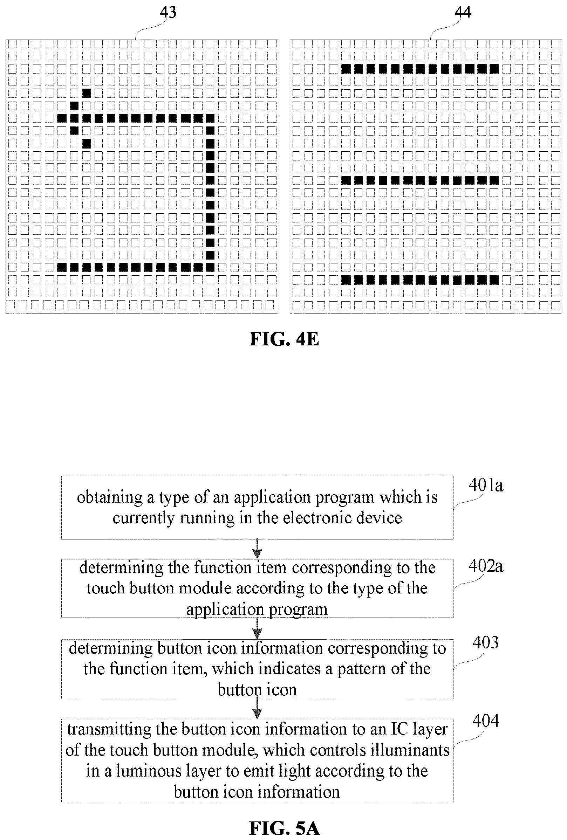

For example, when the application program which is currently running is the social application program, the button icon information corresponding to the function item 43 to "return to the main page of the electronic device" which corresponds to the left touch button module carries information of displaying a return arrow in the button icon. In this situation, a part of the illuminants arranged in an array in the luminous layer are controlled to emit light by the IC layer according to the button icon information, so that the button icon displayed by the light emitted by the illuminants is the "return arrow" icon. The button icon information corresponding to the function item 44 to "show a list of unread messages" which corresponds to the right touch button module carries information of displaying three horizontal lines in the button icon. In this situation, a part of the illuminants arranged in an array in the luminous layer are controlled to emit light by the IC layer according to the button icon information, so that the button icon displayed by the light emitted by the illuminants is the "three horizontal lines" icon, as shown in Fig. 4E.

In conclusion, a method for displaying a button icon is provided in the present disclosure. By obtaining a type of an application program which is currently running in the electronic device; determining a function item corresponding to a touch button module according to the type of the application program; determining button icon information corresponding to the function item; transmitting the button icon information to an IC layer of the touch button module, which may control illuminants in a luminous layer to emit light, the problem may thus be solved that the button icon displayed by a LED light is fixed since a pattern of a hollow area corresponding to the button icon is fixed. In contrary, the button icon information can be determined according to the function item and the illuminants in the luminous layer emit light under the control of the IC layer. Therefore, different function items correspond to different patterns of the button icons, thus achieving a diversity of the patterns of the button icon.

Based on the method for displaying the button icon shown in Fig. 4A, the steps 401 and 402 may be replaced by the following steps in a first possible implementation, as shown in Fig. 5A.

At step 401a, a type of an application program which is currently running in an electronic device is obtained.

The type of the application program which is currently running is obtained by the electronic device.

Alternatively, the type of the application program which is currently running in the electronic device is obtained by a processor of the electronic device through an operating system.

For example, the type of the application program which is currently running obtained by the electronic device is a shopping application program. For example, the type of the application program which is currently running obtained by the electronic device is a social application program.

At step 402a, a function item corresponding to a touch button module is determined according to the type of the application program.

The function item corresponding to the touch button module is determined by the electronic device according to the obtained type of the application program which is currently running.

For the same touch button module, when the type of the application programs which is currently running is different, the function items corresponding to the touch button module may be different, or may be the same.

For example, when the type of the application program which is currently running is type "A", the function item corresponding to the touch button module is "B"; when the type of the application program which is currently running is type "C", the function item corresponding to the touch button module is "D", or the function item corresponding to the touch button module is also "B".

Alternatively, for different types of the application program, the function items corresponding to the touch button module are different.

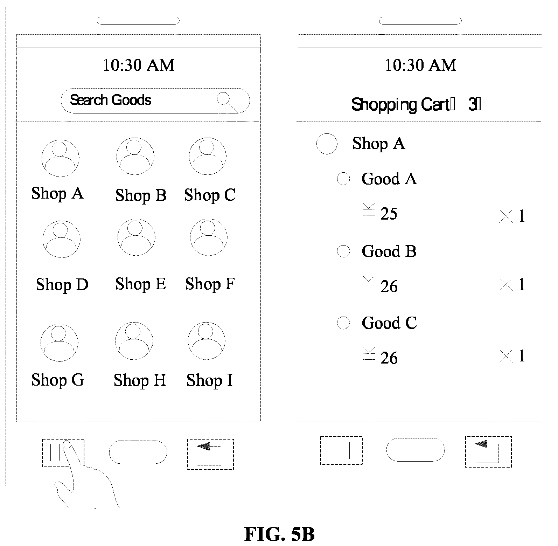

For example, two touch button modules are disposed on the left and right sides of an area between a display screen and a lower edge of the electronic device. When the type of the application program which is currently running is a shopping application program, the function item corresponding to the left touch button module is to "show items in a shopping cart of a logged-in user account", and the function item corresponding to the right touch button module is to "return to the main page of the electronic device", as shown in Fig. 5B.

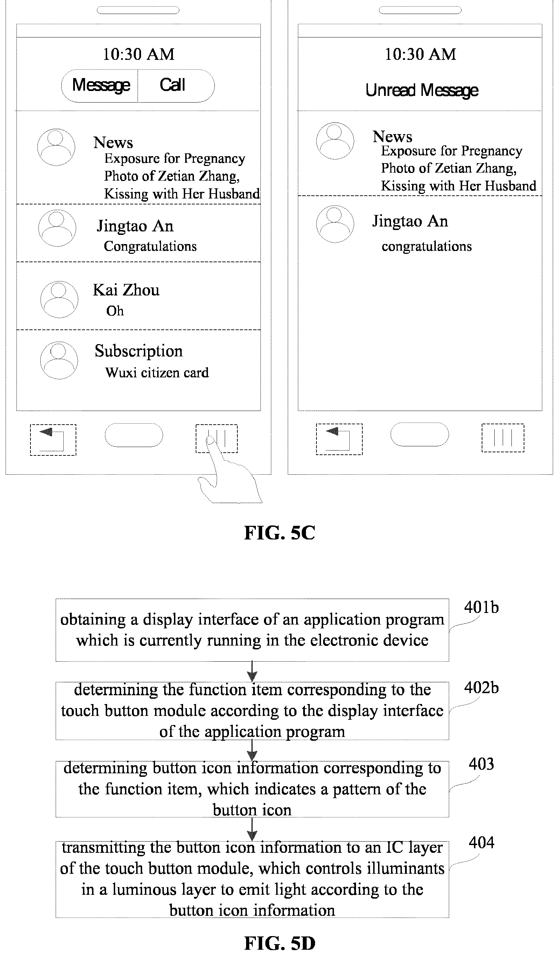

For example, when the type of the application program which is currently running is a social application program, the function item corresponding to the left touch button module is to "return to the main page of the electronic device", and the function item corresponding to the right touch button module is to "show a list of unread messages", as shown in Fig. 5C.

Based on the method for displaying the button icon shown in Fig. 4A, the steps 401 and 402 may be replaced by the following steps in a first possible implementation, as shown in Fig. 5D.

At step 401b, a display interface of an application program which is currently running in an electronic device is obtained.

The display interface of the application program which is currently running is obtained by the electronic device.

Alternatively, the display interface of the application program which is currently running in the electronic device is obtained by a processor of the electronic device through an operating system.

For example, the display interface of the application program which is currently running obtained by the electronic device is a display interface of a shopping application program. For example, the display interface of the application program which is currently running obtained by the electronic device is a display interface of a social application program.

At step 402b, a function item corresponding to the touch button module is determined according to the display interface of the application program.

The function item corresponding to the touch button module is determined by the electronic device, according to the obtained display interface of the application program which is currently running.

Alternatively, for the display interfaces of different application programs, the function items corresponding to the touch button module are different.

For example, two touch button modules are disposed on the left and right sides of an area between a display screen and a lower edge of the electronic device. When the display interface of the application program which is currently running is an interface of a shopping application program, the function item corresponding to the left touch button module is to "show items in a shopping cart of a logged-in user account", and the function item corresponding to the right touch button module is to "return to the main page of the electronic device", as shown in Fig. 5B.

For example, when the display interface of the application program which is currently running is an interface of a social application program, the function item corresponding to the left touch button module is to "return to the main page of the electronic device", and the function item corresponding to the right touch button module is to "show a list of unread messages", as shown in Fig. 5C.

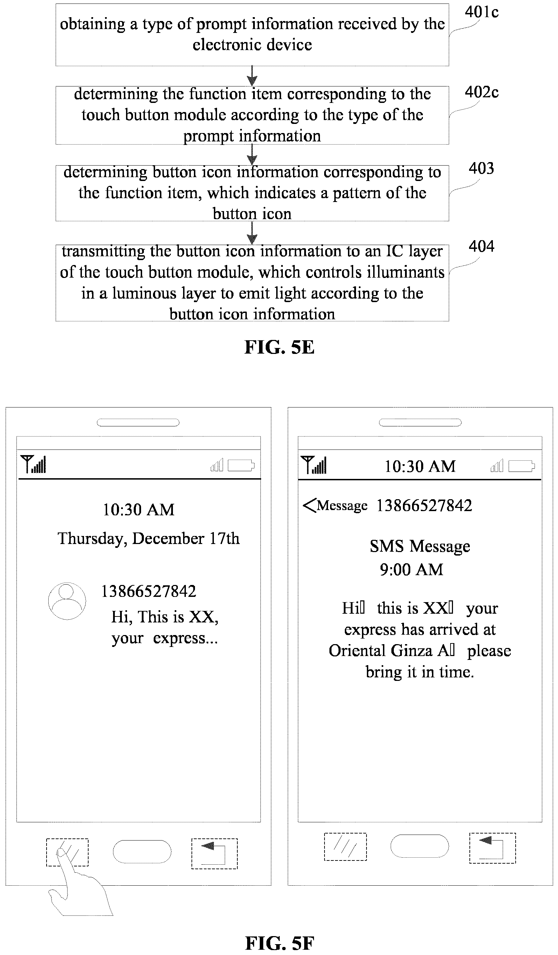

Based on the method for displaying the button icon shown in Fig. 4A, the steps 401 and 402 may be replaced by the following steps in a second possible implementation, as shown in Fig. 5E.

At step 401c, a type of prompt information received by an electronic device is obtained.

The type of the received prompt information is obtained by the electronic device.

Alternatively, the type of the received prompt information is obtained by a processor of the electronic device through an operating system.

For example, the type of the prompt information received by the electronic device is a short message. For example, the type of the prompt information received by the electronic device is prompt information pushed by a third-party application program.

At step 402c, a function item corresponding to a touch button module is determined according to the type of the prompt information.

The function item corresponding to the touch button module is determined by the electronic device according to the type of the prompt information.

Alternatively, for different types of the prompt information, the function items corresponding to the touch button module are different.

For example, two touch button modules are disposed on the left and right sides of an area between a display screen and a lower edge of the electronic device. When the type of the prompt information currently received is a short message, the function item corresponding to the left touch button module is to "read the content of the short message", and the function item corresponding to the right touch button module is to "ignore the prompt and return to the main page of the electronic device", as shown in Fig. 5F.

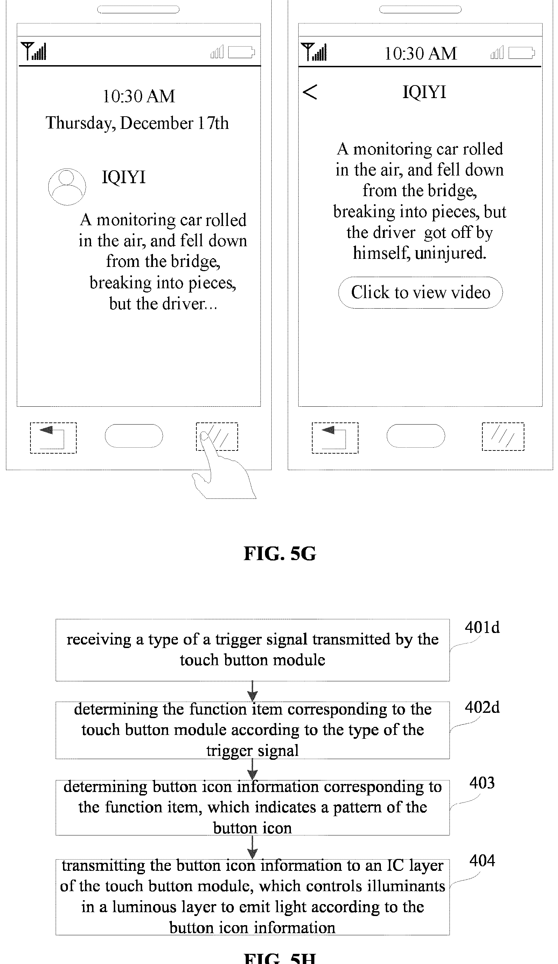

For example, when the type of the prompt information currently received is prompt information pushed by a third-party application program, the function item corresponding to the left touch button module is to "ignore the prompt and return to the main page of the electronic device", and the function item corresponding to the right touch button module is to "obtain the content of the pushed information", as shown in Fig. 5G.

Based on the method for displaying the button icon shown in Fig. 4A, the steps 401 and 402 may be replaced by the following steps a fifth possible implementation, as shown in Fig. 5H.

At step 401d, a type of a trigger signal transmitted by a touch button module is received.

The type of the trigger signal transmitted by the touch button module is received by an electronic device.

The type of the trigger signal transmitted by the touch button module is the type of a trigger signal which is generated by an IC layer of the touch button module according to a touch signal collected by a sensing layer of the touch button module.

For example, the touch signal collected by the sensing layer of the touch button module is a single-click signal or a double-click signal.

At step 402d, a function item corresponding to the touch button module is determined according to the type of the trigger signal.

The function item corresponding to the touch button module is determined by the electronic device, according to the type of the received trigger signal.

Alternatively, for different types of the trigger signal, the function items corresponding to the touch button module are different.

For example, two touch button modules are disposed on the left and right sides of an area between a display screen and a lower edge of the electronic device. When a single-click trigger signal is received by the left touch button module, it is determined that the function item corresponding to the single-click trigger signal of the left touch button module is to "display the main page of the electronic device". When a double-click trigger signal is received by the right touch button module, it is determined that the function item corresponding to the double-click trigger signal of the right touch button module is to "return to the last operation".

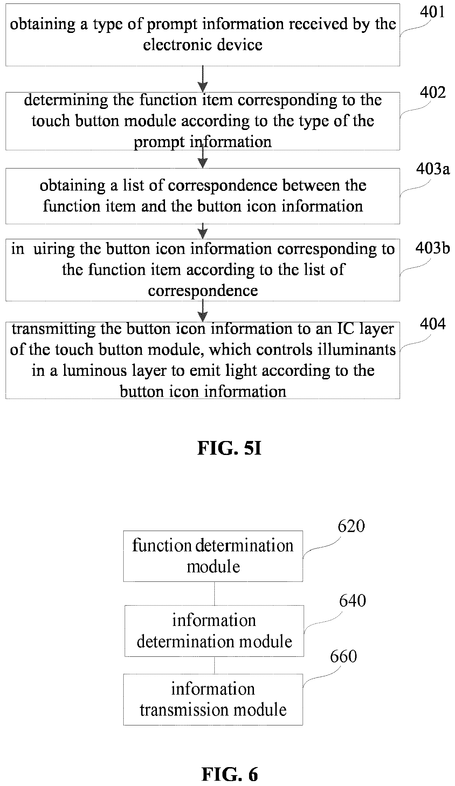

Based on the method for displaying the button icon shown in Fig. 4A, the step 403 may be replaced by the following steps as a possible implementation, as shown in Fig. 5I.

At step 403a, a list of correspondence between a function item and button icon information is obtained.

The list of correspondence between the function item and the button icon information is obtained after the function item corresponding to a touch button module is determined by a processor of an electronic device. The correspondence between the function item and the button icon information is stored in the list of correspondence. That is, when either of the function item and the button icon information is determined, the other one may be determined according to the list of correspondence.

Alternatively, the correspondence between the function item and the button icon information may be a one-to-one correspondence or a many-to-one correspondence.

Alternatively, the list of correspondence between the function item and the button icon information can be obtained by the processor of the electronic device at any time between the step 401 and the step 403. The time when the correspondence list between the function item and the button icon information is obtained by the electronic device is not limited in this embodiment.

At step 403b, the button icon information corresponding to the function item is inquired according to the list of correspondence.

The button icon information corresponding to the function item is inquired by the processor of the electronic device, according to the obtained list of correspondence and the determined function item corresponding to the touch button module.

The following is an apparatus embodiment of the present disclosure to perform the method embodiment of the present disclosure. Refer to the method embodiment of the present disclosure for the unmentioned details in the apparatus embodiment of the present disclosure.

Fig. 6 is a block diagram illustrating an apparatus for displaying a button icon according to an exemplary embodiment. As shown in Fig. 6, the apparatus for displaying the button icon is applied to an electronic device configured with a touch button module as shown in Fig. 2A. The apparatus includes but not limited to: a function determination module 620 configured to determine a function item corresponding to the touch button module; an information determination module 640 configured to determine button icon information corresponding to the function item, which indicates a pattern of the button icon; and an information transmission module 660 configured to transmit the button icon information to an IC layer of the touch button module, which controls illuminants in a luminous layer to emit light according to the button icon information.

In conclusion, an apparatus for displaying the button icon is provided in the embodiment of the present disclosure. By determining a function item corresponding to a touch button module; determining button icon information corresponding to the function item; and transmitting the button icon information to an IC layer of the touch button module, which may control illuminants in a luminous layer to emit light, the problem may thus be solved that the button icon displayed by a LED light is fixed since a pattern of a hollow area corresponding to the button icon is fixed. In contrary, the button icon information can be determined according to the function item and the illuminants in the luminous layer emit light under the control of the IC layer. Therefore, different function items correspond to different patterns of the button icons, thus achieving a diversity of the patterns of the button icon.

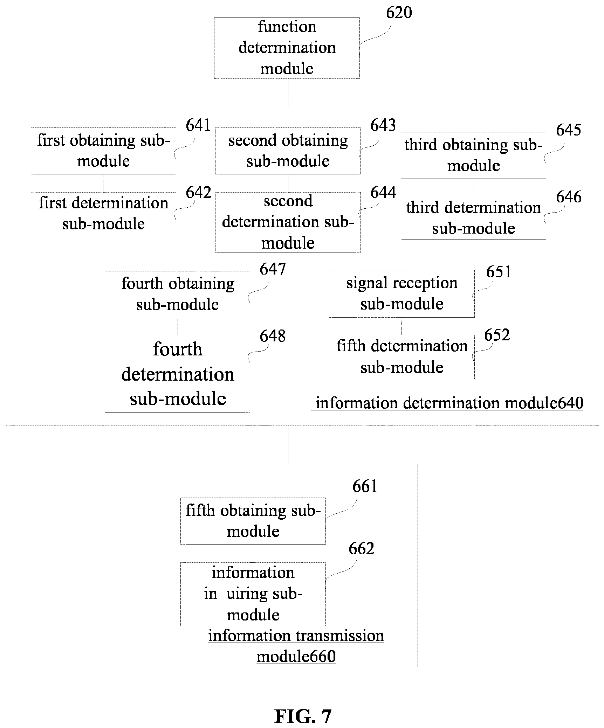

Fig. 7 is a block diagram illustrating an apparatus for displaying a button icon according to another exemplary embodiment. As shown in Fig. 7, the apparatus for displaying the button icon is applied to an electronic device configured with a touch button module as shown in Fig. 2A. The apparatus includes but not limited to: a function determination module 620 configured to determine a function item corresponding to the touch button module; and an information determination module 640 configured to determine button icon information corresponding to the function item, which indicates a pattern of the button icon.

As a first possible implementation, the information determination module 640 may include the following sub-modules: a first obtaining sub-module 641 configured to obtain function information pre-defined in the electronic device by a user, which includes a correspondence between the touch button module and the function item; and a first determination sub-module 642 configured to determine the function item corresponding to the touch button module, according to the function information.

As a second possible implementation, the information determination module 640 may include the following sub-modules: a second obtaining sub-module 643 configured to obtain a type of an application program which is currently running in the electronic device; and a second determination sub-module 644 configured to determine the function item corresponding to the touch button module, according to the type of the application program.

As a third possible implementation, the information determination module 640 may include the following sub-modules: a third obtaining sub-module 645 configured to obtain a display interface of an application program which is currently running in the electronic device; and a third determination sub-module 646 configured to determine the function item corresponding to the touch button module, according to the display interface of the application program.

As a fourth possible implementation, the information determination module 640 may include the following sub-modules: a fourth obtaining sub-module 647 configured to obtain a type of prompt information received by the electronic device; and a fourth determination sub-module 648 configured to determine the function item corresponding to the touch button module, according to the type of the prompt information.

As a sixth possible implementation, the information determination module 640 may include the following sub-modules: a signal reception sub-module 651 configured to obtain a type of a trigger signal transmitted by the touch button module; a fifth determination sub-module 652 configured to determine the function item corresponding to the touch button module, according to the type of the trigger signal; and a information transmission module 660 configured to transmit the button icon information to an IC layer of the touch button module, which controls illuminants in a luminous layer to emit light according to the button icon information.

As a possible implementation, the information transmission module 660 may include the following sub-modules: a fifth obtaining sub-module 661 configured to obtain a list of correspondence between the function item and the button icon information; and an information inquiring sub-module 662 configured to inquire the button icon information corresponding to the function item, according to the list of correspondence.

In conclusion, an apparatus for displaying the button icon is provided in the embodiment of the present disclosure. By obtaining a type of an application program which is currently running in the electronic device; determining a function item corresponding to a touch button module according to the type of the application program; determining button icon information corresponding to the function item; transmitting the button icon information to an IC layer of the touch button module, which may control illuminants in a luminous layer to emit light, the problem of the state of the art may thus be solved that the button icon displayed by a LED light is fixed since a pattern of a hollow area corresponding to the button icon is fixed. In contrary in the present invention, the button icon information can be determined according to the function item and the illuminants in the luminous layer emit light under the control of the IC layer. Therefore, different function items correspond to different patterns of the button icons, thus achieving a diversity of the patterns of the button icon.

Specific manners in which each module of the apparatus performs operations have been described in detail in the embodiment of the related method, which will not be described in detail here.

An apparatus for displaying a button icon is provided by an exemplary embodiment of the present disclosure, which is able to implement a method for displaying a button icon provided by the present disclosure. The apparatus includes a processor and a memory to store processor-executable instructions; wherein the processor is configured to: determine a function item corresponding to a touch button module; determine button icon information corresponding to the function item, which indicates a pattern of the button icon; and transmit the button icon information to an IC layer of the touch button module, which controls illuminants in a luminous layer to emit light according to the button icon information.

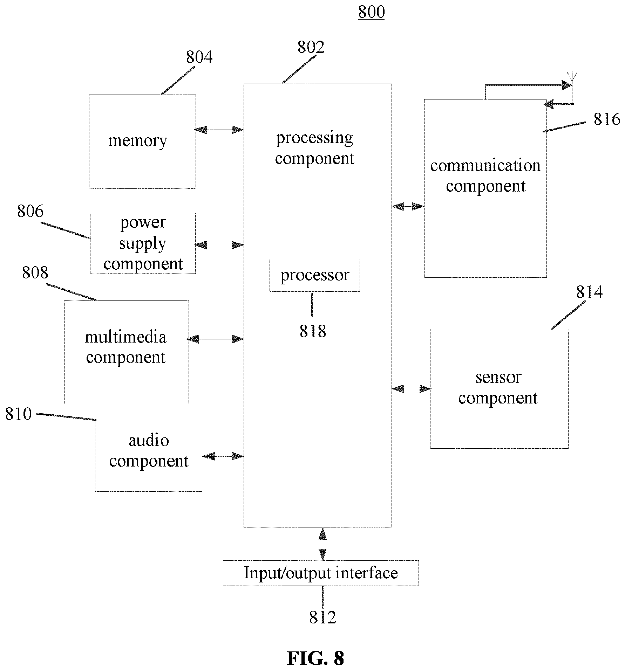

Fig. 8 is a block diagram illustrating an apparatus for displaying a button icon according to an exemplary embodiment. For example, the apparatus 800 may be a mobile phone, a computer, a digital broadcast terminal, a message transceiver, a game console, a tablet device, a medical device, a fitness device, a personal digital assistant, etc.

Referring to Fig. 8, the apparatus 800 may include one or more of the following components: a processing component 802, a memory 804, a power supply component 806, a multimedia component 808, an audio component 810, an input/output (I/O) interface 812, a sensor component 814, and a communication component 816.

In general, overall operations of the apparatus 800 is controlled by the processing component 802, such as operations in association with display, telephone calls, data communications, camera operations and recording operations. The processing component 802 may include one or more processors 802 to perform instructions, in order to complete all or part of the methods described above. Furthermore, the processing component 802 may include one or more modules to facilitate an interaction between the processing component 802 and other components. For example, the processing component 802 may include a multimedia module to facilitate an interaction between the multimedia component 808 and the processing component 802.

The memory 804 is configured to store various types of data to support operations on the apparatus 800. These examples of data include instructions, contact data, phonebook data, messages, photos, videos, etc, for any application program or method operated on the apparatus 800. The memory 804 may be implemented by any type of volatile or non-volatile storage device, or the combination thereof, such as static random access memory (SRAM), electrically erasable programmable read-only memory (EEPROM), electrically programmable read-only memory (EPROM), programmable read-only memory (PROM), read-only memory (ROM), magnetic memory, flash memory, magnetic disks, or optical disks.

Power supply is provided for various components of the apparatus by the power supply component 806. The power supply component 806 may include a power supply management system, one or more power supplies, and other components in association with generation, management and assignment of the power for the apparatus 800.

The multimedia component 808 includes a screen located between the apparatus 800 and a user, providing an output interface. In some embodiments, the screen may include a liquid crystal display (LCD) and a touch panel (TP). If the screen includes the touch panel, the screen may be implemented as a touch screen to receive an input signal from the user. The touch panel includes one or more touch sensors to sense touches, swipes, and gestures on the touch panel. The touch sensor not only may sense the action boundary of the touching or sliding, but also detect the duration and pressure in relation to the touching or sliding operation. In some embodiments, the multimedia component 808 includes a front camera and/or a rear camera. When the apparatus is in an operating mode, such as a shooting mode or a video mode, multimedia data outside may be received by the front camera and/or the rear camera. Each front camera and rear camera may be a fixed optical lens system or have optical focusing and zooming capability.

The audio component 810 is configured to output and/or input an audio signal. For example, the audio component 810 includes a microphone (MIC), when the apparatus 800 is in the operating mode, such as a calling mode, a recording mode and a voice recognition mode, the microphone is configured to receive an audio signal outside. The received audio signal may be further stored in the memory 804 or transmitted via the communication component 816. In some embodiments, the audio component 810 further includes a speaker to output the audio signal.

An interface between the processing component 802 and a peripheral interface is provided by the I/O interface 812, and the peripheral interface described above may include but be not limited to a keyboard, a click wheel, a button, etc. These buttons may include but be not limited to a home button, a volume button, a start button and a lock button.

The sensor component 814 includes one or more sensors to provide state assessments of various aspects for the apparatus 800. For example, sensor component 814 may detect the on/off state, the relative positioning for components of the apparatus 800, for example, the components are a display and a keypad of the apparatus 800, and the sensor component 814 may further detect the position changing of the apparatus 800 or one component of the apparatus 800, whether the contact between the user and the apparatus 800 exists or not, the location or acceleration/deceleration of the apparatus 800, and the temperature changing of the apparatus 800. The sensor component 814 may include a proximity sensor, configured to detect the existence of proximity objects when there is no physical contact. The sensor component 814 may further include an optical sensor, such as a CMOS or a CCD image sensor, for the utilization in an imaging application. In some embodiments, the sensor component 814 may further include an acceleration sensor, a gyroscope sensor, a magnetic sensor, a pressure sensor or a temperature sensor.

The communication component 816 is configured to facilitate the wired or wireless communication between the apparatus 800 and other devices. The apparatus 800 may access a wireless network based on a communication standard, such as Wi-Fi, 2G or 3G, or the combination thereof. In one exemplary embodiment, a broadcast signal or a broadcast related message from broadcast management system outside may be received by the communication component 816 via a broadcast channel. In one exemplary embodiment, the communication component 816 further includes a near field communication (NFC) module to promote short range communication. For example, the NFC module may be implemented based on the radio frequency identification devices (RFID) technique, the infrared data association (IrDA) technique, the ultra wide band radio (UWB) technique, the Bluetooth (BT) technique and other techniques.

In exemplary embodiments, the apparatus 800 may be implemented by one or more application specific integrated circuits (ASIC), digital signal processors (DSP), digital signal processor devices (DSPD), programmable logic devices (PLD), field programmable gate arrays (FPGA), controllers, micro controllers, micro processors, or other electronic elements, to perform the method for the display of the button icon mentioned above.

In exemplary embodiments, a non-transitory computer readable storage media, including instructions, is provided, such as the memory 804 including instructions, and the instructions mentioned above may be performed by the processor 818 of the apparatus 800 to implement the method for the display of the button icon mentioned above. For example, the non-transitory computer readable storage media may be a ROM, a random-access memory (RAM), a CD-ROM, a tape, a floppy disk, and an optical data storage device.

Other embodiments of the disclosure will be apparent to those skilled in the art from consideration of the specification and practice of the disclosures herein. This application is intended to cover any variations, uses, or adaptations of the disclosure following the general principles thereof and including common sense or customary technical means in the art that is not disclosed in the disclosure. It is intended that the specification and examples be considered as exemplary only, with a true scope of the disclosure being indicated by the following claims.

It will be appreciated that the inventive concept is not limited to the exact construction that has been described above and illustrated in the accompanying drawings, and that various modifications and changes may be made without departing from the scope thereof. It is intended that the scope of the invention is only limited by the appended claims.

## Claims

1. A touch button module, **characterized by**:
a sensing layer (110), a luminous layer (140), an integrated circuit (IC) layer (120), and a pin (130), which are wholly integrated, wherein
the luminous layer (140) is located below the sensing layer (110), which comprises a plurality of illuminants (141) arranged in an array;
the IC layer (120) is located below the luminous layer (140);
the pin (130) is located below the IC layer (120); and
the sensing layer (110) is electrically connected to the IC layer (120) through a first conductive line (121), the luminous layer (140) is electrically connected to the IC layer (120) through a second conductive line (122), and the pin (130) is electrically connected to the IC layer (120) through a third conductive line (123).

2. The touch button module of claim 1, wherein light transmittance of the sensing layer (110) is greater than a pre-defined threshold, in particular semitransparent or transparent.

3. A method for displaying a button icon, which is applied to an electronic device configured with a touch button module of claim 1 or 2, **characterized by**:
determining (301) a function item corresponding to the touch button module;
determining (302) button icon information corresponding to the function item, which indicates a pattern of the button icon; and
transmitting (303) the button icon information to an IC layer of the touch button module, which controls illuminants in a luminous layer to emit light according to the button icon information.

4. The method of claim 3, wherein the determining (301) the function item corresponding to the touch button module comprises:
obtaining (401) function information pre-defined in the electronic device by a user, which comprises a correspondence between the touch button module and the function item; and
determining (402) the function item corresponding to the touch button module according to the function information.

5. The method of claim 3, wherein the determining (301) the function item corresponding to the touch button module comprises:
obtaining (401 a) a type of an application program which is currently running in the electronic device; and
determining (402a) the function item corresponding to the touch button module according to the type of the application program.

6. The method of claim 3, wherein the determining (301) the function item corresponding to the touch button module comprises:
obtaining (401b) a display interface of an application program which is currently running in the electronic device; and
determining (402b) the function item corresponding to the touch button module according to the display interface of the application program.

7. The method of claim 3, wherein the determining (301) the function item corresponding to the touch button module comprises:
obtaining (401c) a type of prompt information received by the electronic device; and
determining (402c) the function item corresponding to the touch button module according to the type of the prompt information.

8. The method of claim 3, wherein the determining (301) the function item corresponding to the touch button module comprises:
Receiving (401 d) a type of a trigger signal transmitted by the touch button module; and
determining (402d) the function item corresponding to the touch button module according to the type of the trigger signal.

9. The method of any of claims 3 to 8, wherein the determining (302) the button icon information corresponding to the function item comprises:
obtaining (403a) a list of correspondence between the function item and the button icon information; and
inquiring (403b) the button icon information corresponding to the function item according to the list of correspondence.

10. An apparatus for displaying a button icon, which is applied to an electronic device configured with the touch button module of claim 1 or 2, **characterized by**:
a function determination module (620) configured to determine a function item corresponding to the touch button module;
an information determination module (640) configured to determine button icon information corresponding to the function item, which indicates a pattern of the button icon; and
an information transmission module (660) configured to transmit the button icon information to an IC layer of the touch button module, which controls illuminants in a luminous layer to emit light according to the button icon information.

11. The apparatus of claim 10, wherein the function determination module (620) comprises:
a first obtaining sub-module (641) configured to obtain function information pre-defined in the electronic device by a user, which comprises a correspondence between the touch button module and the function item; and
a first determination sub-module (642) configured to determine the function item corresponding to the touch button module according to the function information, or
a second obtaining sub-module (643) configured to obtain a type of an application program which is currently running in the electronic device; and
a second determination sub-module (644) configured to determine the function item corresponding to the touch button module according to the type of the application program.

12. The apparatus of claim 11, wherein the function determination module (620) comprises:
a third obtaining sub-module (645) configured to obtain a display interface of an application program which is currently running in the electronic device; and
a third determination sub-module (646) configured to determine the function item corresponding to the touch button module according to the display interface of the application program, or
a fourth obtaining sub-module (647) configured to obtain a type of prompt information received by the electronic device; and
a fourth determination sub-module (648) configured to determine the function item corresponding to the touch button module according to the type of the prompt information.

13. The apparatus of claim 11, wherein the function determination module (320) comprises:
a signal reception sub-module (651) configured to obtain a type of a trigger signal transmitted by the touch button module; and
a fifth determination sub-module (652) configured to determine the function item corresponding to the touch button module according to the type of the trigger signal.

14. The apparatus of any of claims 11 to 13, wherein the information determination module (640) comprises:
a fifth obtaining sub-module (661) configured to obtain a list of correspondence between the function item and the button icon information; and
an information inquiring sub-module (662) configured to inquire the button icon information corresponding to the function item according to the list of correspondence.

15. An apparatus for displaying a button icon, **characterized by**:
a processor (818); and
a memory (804) to store processor-executable instructions;
the processor (818) is electrically connected to a touch button module through a conductive line on a mainboard;
wherein the processor (818) is configured to:
determine a function item corresponding to the touch button module;
determine button icon information corresponding to the function item, which indicates a pattern of the button icon; and
transmit the button icon information to an IC layer of the touch button module, which controls illuminants in a luminous layer to emit light according to the button icon information.
